# FASCICULE DE BREVET EUROPEEN

(11) **EP 3 496 132 B1**
(45) Date de publication et mention de la délivrance du brevet: **02.02.2022**
(21) Numéro de dépôt: 18209594.3
(22) Date de dépôt: 30.11.2018
(51) Int. Cl.: H01L 21/18

(54) **PROCEDE DE COLLAGE PAR ADHESION DIRECTE**
KLEBEVERFAHREN DURCH DIREKTADHÄSION
METHOD OF BONDING BY DIRECT ADHESION

(30) Priorité: 08.12.2017 FR 1761828
(43) Date de publication de la demande: 12.06.2019
(73) Titulaire: Commissariat à l'Energie Atomique et aux Energies Alternatives, 75015 Paris (FR)
(72) Inventeur: FOURNEL, Frank, 38190 VILLARD-BONNOT (FR); LARREY, Vincent, 38140 LA MURETTE (FR); MORALES, Christophe, 38220 SAINT PIERRE DE MESAGE (FR); TEDJINI, Marwan, 38600 FONTAINE (FR)
(74) Mandataire: INNOV-GROUP

(56) Documents cités:
- US-A1- 2008 014 712
- US-A1- 2008 196 747
- US-A1- 2011 129 986

## Description

### Domaine technique

L'invention se rapporte au domaine technique du collage par adhésion directe de deux substrats.

L'invention trouve notamment son application dans le transfert de couches minces pour la fabrication de dispositifs électroniques.

### Etat de la technique antérieure

Un procédé de collage par adhésion directe connu de l'état de la technique, notamment du document M. Tedjini et al., « Interface water diffusion in silicon direct bonding », Appl. Phys. Lett., 109, 111603, 2016 (ci-après D1), comporte les étapes :
a₀) prévoir des premier et deuxième substrats, comprenant chacun une première surface et une seconde surface opposée ;
b₀) coller le premier substrat au deuxième substrat par une adhésion directe avec les premières surfaces des premier et deuxième substrats de manière à former une interface de collage.

D1 enseigne que l'interface de collage n'est pas isolée de l'atmosphère sous laquelle est exécutée l'étape b₀). En particulier, des molécules d'eau peuvent pénétrer l'interface de collage, avec une certaine cinétique, et ce tant qu'une étape c₀) de recuit thermique à haute température (supérieure à 1000°C) n'est pas exécutée. Cette pénétration des molécules d'eau à l'interface de collage conduit à la création de défauts et à la modification de l'adhérence de l'interface de collage.

Un tel procédé de l'état de la technique n'est donc pas entièrement satisfaisant dans la mesure où il apparaît nécessaire :
(i) soit de contrôler l'atmosphère (en particulier le taux d'humidité) sous laquelle est exécutée l'étape b₀) jusqu'au moment de l'exécution de l'étape c₀) ;
(ii) soit d'exécuter l'étape c₀) rapidement après l'étape b₀), i.e. plus rapidement que la cinétique de progression de l'eau dans l'interface de collage, ce qui suppose une gestion contraignante des temps d'attente des substrats collés.

Par ailleurs, selon l'application envisagée, des étapes intermédiaires entre les étapes b₀) et c₀) sont susceptibles de devoir être exécutées dans un environnement très humide, et donc potentiellement dégradant pour l'interface de collage. On peut citer par exemple :
- une étape de caractérisation acoustique avant l'étape co), ou
- une étape de meulage («*grinding*» en langue anglaise) avant l'étape c₀), permettant d'amincir des hétérostructures afin de supporter le recuit thermique malgré des coefficients de dilatation thermique différents. Les documents US 2008/196747 A1, US 2008/014712 A1 et US 2011/129986 A1 décrivent des procédés de collage de deux substrats par adhésion directe.

### Exposé de l'invention

L'invention vise à remédier en tout ou partie aux inconvénients précités. A cet effet, l'invention a pour objet un procédé de collage par adhésion directe d'un premier substrat à un deuxième substrat, comportant les étapes successives :
a) prévoir les premier et deuxième substrats, comprenant chacun :
   - une première surface et une seconde surface opposée ;
   - des bords latéraux reliant les première et seconde surfaces ;
b) coller le premier substrat au deuxième substrat par une adhésion directe avec les premières surfaces des premier et deuxième substrats de manière à former une interface de collage ; l'étape b) étant un collage hydrophile entre les premier et deuxième substrats;
c) rendre hydrophobes les bords latéraux des premier et deuxième substrats, de part et d'autre de l'interface de collage.

Ainsi, un tel procédé selon l'invention permet, grâce à l'étape c), d'isoler l'interface de collage de l'atmosphère environnante, en particulier des molécules d'eau, qui ne peuvent y pénétrer. Il n'est pas donc pas nécessaire de contrôler l'atmosphère, en particulier son taux d'humidité. En outre, une étape de recuit thermique à haute température (supérieure à 1000°C) peut alors être exécutée ultérieurement sans contrainte de temps d'attente, en l'absence de craintes concernant la cinétique de progression de l'eau dans l'interface de collage.

Cette isolation de l'interface de collage conférée par l'étape c) est localisée sur les bords latéraux des premier et deuxième substrats, de part et d'autre de l'interface de collage (donc sans pénétrer l'interface de collage), et ce afin de ne pas détériorer l'interface de collage lors de l'exécution de l'étape c). Il est à noter que l'isolation de l'interface de collage conférée par l'étape c) peut s'étendre aux secondes surfaces des premier et deuxième substrats. En d'autres termes, il est possible de rendre également hydrophobes les secondes surfaces des premier et deuxième substrats lors de l'étape c), pour des raisons de simplicité de mise en œuvre. Toutefois, le caractère hydrophobe des secondes surfaces des premier et deuxième substrats n'a pas d'effet technique sur la pénétration des molécules d'eau dans l'interface de collage, contrairement au caractère hydrophobe des bords latéraux des premier et deuxième substrats.

### Définitions

- Par « substrat», on entend un support physique autoporté, réalisé dans un matériau de base permettant la fabrication d'un dispositif électronique ou d'un composant électronique. Un substrat est classiquement une tranche (« *wafer»* en langue anglaise) découpée dans un lingot monocristallin de matériau semi-conducteur.
- Par « adhésion directe », on entend un collage spontané issu de la mise en contact direct de deux surfaces, c'est-à-dire en l'absence d'un élément additionnel tel qu'une colle, une cire ou une brasure. L'adhésion provient principalement des forces de van der Waals issues de l'interaction électronique entre les atomes ou les molécules de deux surfaces, des liaisons hydrogène du fait des préparations des surfaces ou des liaisons covalentes établies entre les deux surfaces. On parle également de collage par adhésion moléculaire ou de collage direct. Le collage par adhésion directe est avantageusement effectué à température et pression ambiantes, et ne saurait être assimilé à un collage par thermocompression, à un collage eutectique, ou encore à un collage anodique. Le collage par adhésion directe peut être suivi d'un recuit thermique de renforcement.
- Par « hydrophobe », on entend une surface caractérisée par un angle de contact avec une goutte d'eau compris entre 50° et 180°, de préférence compris entre 70° et 180°, plus préférentiellement compris entre 90° et 180°, encore plus préférentiellement compris entre 90° et 150°.

Le procédé selon l'invention peut comporter une ou plusieurs des caractéristiques suivantes.

Selon une caractéristique de l'invention, l'étape c) est exécutée par une formation d'une couche sur les bords latéraux des premier et deuxième substrats, de part et d'autre de l'interface de collage, ladite couche étant réalisée dans un matériau hydrophobe.

Ainsi, un avantage procuré par une couche dédiée est de pouvoir assurer le caractère hydrophobe quel que soit le matériau des premier et deuxième substrats.

Selon une caractéristique de l'invention, le matériau hydrophobe est sélectionné parmi la paraffine ou un revêtement fluoré.

Selon une caractéristique de l'invention, l'étape c) est exécutée par un traitement hydrophobe des bords latéraux des premier et deuxième substrats, de part et d'autre de l'interface de collage.

Ainsi, un avantage procuré par un traitement hydrophobe des bords latéraux est la simplicité de mise en œuvre. Il n'est pas nécessaire de former puis d'enlever une couche dédiée.

Selon une caractéristique de l'invention, le traitement hydrophobe est un traitement chimique, de préférence appliqué avec une solution acide ou avec des vapeurs acides.

Selon une caractéristique de l'invention, le traitement hydrophobe est un traitement de surface, de préférence appliqué avec un plasma, plus préférentiellement un plasma fluoré.

Selon une caractéristique de l'invention, l'étape b) est suivie d'une étape consistant à appliquer un traitement thermique aux premier et deuxième substrats collés, le traitement thermique étant exécuté à une température comprise entre 100°C et 300°C.

Ainsi, un avantage procuré par un tel traitement thermique est de réduire la cinétique de progression de l'eau dans l'interface de collage, et ce sans fermer l'interface de collage, c'est-à-dire que les molécules d'eau peuvent encore pénétrer dans l'interface de collage où il reste des espaces vides. Un tel traitement thermique autorise un temps d'attente plus long avant d'exécuter l'étape c), sans risque de détérioration de l'interface de collage.

Selon une caractéristique de l'invention, l'étape b) est exécutée à une température comprise entre 20°C et 30°C.

Ainsi, l'étape b) de collage est exécutée à température ambiante.

Selon une caractéristique de l'invention, l'étape c) est exécutée à l'issue de l'étape b), après une durée d'attente inférieure à 6 heures, de préférence inférieure à 1 heure, plus préférentiellement inférieure à 15 minutes.

Ainsi, un avantage procuré par de telles durées d'attente est d'exécuter l'étape c) suffisamment tôt, c'est-à-dire avant les effets de la cinétique de progression de l'eau dans l'interface de collage.

Selon une caractéristique de l'invention, les bords latéraux des premier et deuxième substrats prévus lors de l'étape a) sont réalisés dans un matériau sélectionné parmi Si, Ge, un oxyde de silicium, SiC, un matériau III-V, un matériau II-VI.

Par « matériau A-B », on entend un alliage binaire entre des éléments situés respectivement dans la colonne A et dans la colonne B du tableau périodique des éléments.

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 est une vue schématique en coupe selon la normale aux première surfaces -et secondes surfaces- des premier et deuxième substrats, illustrant un collage direct de deux substrats à bords arrondis.
Figure 2 est une vue schématique en coupe selon la normale aux première surfaces -et secondes surfaces- des premier et deuxième substrats, illustrant un collage direct de deux substrats à bords arrondis, et recouverts chacun d'un oxyde.
Figure 3 est une vue schématique en coupe selon la normale aux première surfaces -et secondes surfaces- des premier et deuxième substrats, illustrant la formation d'une couche hydrophobe sur les bords latéraux arrondis des substrats.
Figure 4 est une vue schématique en coupe selon la normale aux première surfaces -et secondes surfaces- des premier et deuxième substrats, illustrant un collage direct de deux substrats à bords francs.
Figure 5 est une vue schématique en coupe selon la normale aux première surfaces -et secondes surfaces- des premier et deuxième substrats, illustrant la formation d'une couche hydrophobe sur les bords latéraux francs des deux substrats.
Figures 6a et 6b sont des images obtenues par microscopie acoustique, illustrant les effets respectivement d'une présence et d'une absence d'une couche hydrophobe sur la qualité de l'interface de collage, l'interface de collage étant immergée pendant une semaine dans de l'eau liquide après la formation de la couche hydrophobe.
Figures 7a et 7b sont des images obtenues par microscopie acoustique, illustrant les effets respectivement d'une présence et d'une absence d'une couche hydrophobe sur la qualité de l'interface de collage, l'interface de collage étant soumise à un stockage pendant une semaine dans de l'air humide (à 45% d'humidité relative) après la formation de la couche hydrophobe.
Figures 8a et 8b sont des images obtenues par microscopie acoustique, illustrant les effets respectivement d'une présence et d'une absence d'une couche hydrophobe sur la qualité de l'interface de collage, l'interface de collage étant immergée pendant deux semaines dans de l'eau liquide avant la formation de la couche hydrophobe. Après la formation de la couche hydrophobe, les collages sont stockés pendant 2 jours.

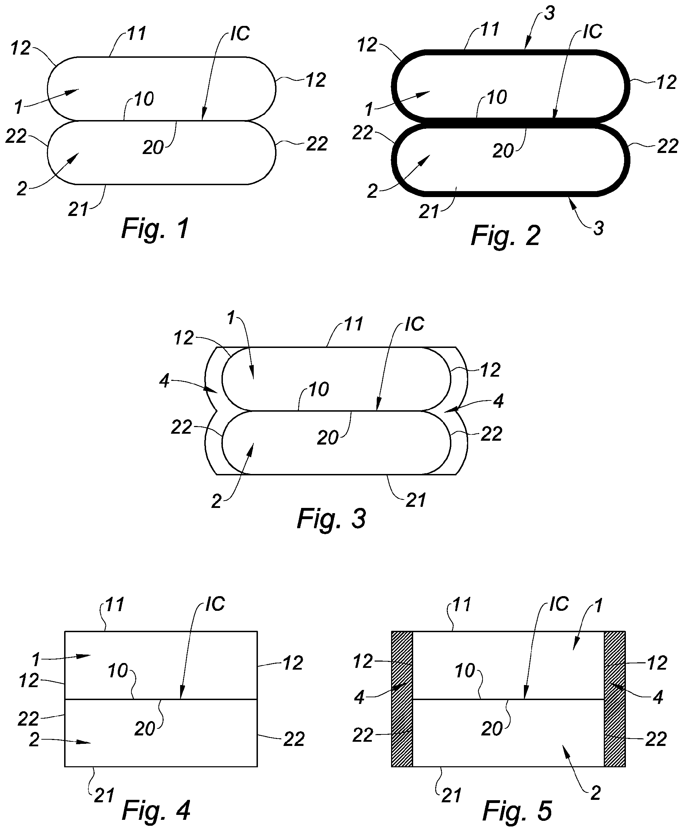

Figures 1 à 5 ne sont pas représentées à l'échelle pour en simplifier leur compréhension.

### Exposé détaillé des modes de réalisation

Les éléments identiques ou assurant la même fonction porteront les mêmes références pour les différents modes de réalisation, par souci de simplification.

Un objet de l'invention est un procédé de collage par adhésion directe d'un premier substrat 1 à un deuxième substrat 2, comportant les étapes successives :
a) prévoir les premier et deuxième substrats 1, 2, comprenant chacun :
   - une première surface 10, 20 et une seconde surface 11, 21 opposée ;
   - des bords latéraux 12, 22 reliant les première et seconde surfaces 10, 20, 11, 21 ;
b) coller le premier substrat 1 au deuxième substrat 2 par une adhésion directe avec les premières surfaces 10, 20 des premier et deuxième substrats 1, 2 de manière à former une interface de collage IC ;
c) rendre hydrophobes les bords latéraux 12, 22 des premier et deuxième substrats 1, 2, de part et d'autre de l'interface de collage IC.

### Premier et deuxième substrats

Les premier et/ou deuxième substrats 1, 2 peuvent être réalisés dans un matériau semi-conducteur. Les premier et/ou deuxième substrats 1, 2 peuvent être recouverts d'un oxyde 3.

Les bords latéraux 12, 22 des premier et deuxième substrats 1, 2 prévus lors de l'étape a) peuvent être réalisés dans un matériau sélectionné parmi Si, Ge, un oxyde de silicium, SiC, un matériau III-V, un matériau II-VI.

Comme illustré aux figures 1 à 3, les bords latéraux 12, 22 des premier et deuxième substrats 1, 2 peuvent être des bords arrondis, en raison de la présence de chanfreins. Comme illustré aux figures 4 et 5, les bords latéraux 12, 22 des premier et deuxième substrats 1, 2 peuvent être des bords francs.

### Etape b) de collage

L'étape b) est préférentiellement exécutée à température ambiante, c'est-à-dire à une température comprise entre 20°C et 30°C. Toutefois, l'étape b) peut être exécutée à plus haute température, par exemple entre 200°C et 400°C.

L'étape b) peut être exécutée à pression ambiante.

L'étape b) est un collage hydrophile entre les premier et deuxième substrats 1, 2. Par « hydrophile », on entend une surface caractérisée par un angle de contact avec une goutte d'eau inférieur ou égal à 40°, de préférence inférieur ou égal à 10°.

### Etape c) : bords latéraux rendus hydrophobes

Selon un premier mode de mise en œuvre, l'étape c) est exécutée par une formation d'une couche 4 sur les bords latéraux 12, 22 des premier et deuxième substrats 1, 2, de part et d'autre de l'interface de collage IC, ladite couche 4 étant réalisée dans un matériau hydrophobe. Le matériau hydrophobe est avantageusement sélectionné parmi la paraffine ou un revêtement fluoré. A titre d'exemples non limitatifs, lorsque les premier et deuxième substrats 1, 2 sont réalisés en silicium ou recouverts d'un oxyde de silicium, le revêtement fluoré peut être :
- un vernis Novec^{™} 2702, commercialisé par la société 3M^{™} ;
- un vernis Novec^{™} 1700, commercialisé par la société 3M^{™} .

Selon un second mode de mise en œuvre, l'étape c) est exécutée par un traitement hydrophobe des bords latéraux 12, 22 des premier et deuxième substrats 1, 2, de part et d'autre de l'interface de collage IC.

Selon une première variante, le traitement hydrophobe est un traitement chimique, de préférence appliqué avec une solution acide ou avec des vapeurs acides. Lorsque les premier et deuxième substrats 1, 2 sont réalisés en silicium, le traitement chimique peut être appliqué avec une solution de HF ou avec des vapeurs de HF. Lorsque les premier et deuxième substrats 1, 2 sont réalisés en InP, le traitement chimique peut être appliqué avec une solution de HCl ou avec des vapeurs de HCl. Un tel traitement chimique peut également rendre hydrophobes les secondes surfaces 11, 21 des premier et deuxième substrats 1, 2, sans toutefois avoir d'effet technique sur la pénétration des molécules d'eau dans l'interface de collage IC.

Selon une seconde variante, le traitement hydrophobe est un traitement de surface, de préférence appliqué avec un plasma, plus préférentiellement un plasma fluoré. Le plasma fluoré peut être un plasma de CF₄ ou de CHF₃. Lorsque les premier et deuxième substrats 1, 2 sont réalisés en silicium ou recouverts de dioxyde de silicium, le traitement de surface peut être appliqué avec un plasma de CF₄. Un tel traitement de surface peut également rendre hydrophobes les secondes surfaces 11, 21 des premier et deuxième substrats 1, 2, sans toutefois avoir d'effet technique sur la pénétration des molécules d'eau dans l'interface de collage IC.

L'étape c) est exécutée à l'issue de l'étape b), avantageusement après une durée d'attente inférieure à 6 heures, de préférence inférieure à 1 heure, plus préférentiellement inférieure à 15 minutes. L'attente entre les étapes b) et c) s'effectue avantageusement sous une atmosphère sèche, c'est-à-dire comportant moins de 1 ppm d'eau.

### Traitement thermique : réduction de la cinétique de progression de l'eau

L'étape b) est avantageusement suivie d'une étape b₁) consistant à appliquer un traitement thermique aux premier et deuxième substrats collés 1, 2, le traitement thermique étant exécuté à une température comprise entre 100°C et 300°C. L'étape b₁) est exécutée avant l'étape c).

### Recuit thermique : renforcement de l'interface de collage

Le procédé comporte avantageusement une étape d) consistant à appliquer un recuit thermique aux premier et deuxième substrats collés 1, 2, l'étape d) étant exécutée après l'étape c). Le recuit thermique appliqué lors de l'étape d) est avantageusement exécuté à une température supérieure ou égale à 1000°C.

Le procédé comporte avantageusement une étape, exécutée immédiatement avant l'étape d), et consistant à :
- retirer la couche 4 formée lors de l'étape c) ;
- ou annihiler le traitement hydrophobe appliqué lors de l'étape c).

### Exemple de mise en œuvre n°1

Les premier et deuxième substrats 1, 2 sont deux tranches de silicium <001> de 200 mm de diamètre et de 725 µm d'épaisseur. Les premier et deuxième substrats 1, 2 sont nettoyés et hydrolysés dans des bains d'eau déionisée enrichie en ozone et dans une solution d'APM (« *Ammonia-Peroxyde Mixture* » en langue anglaise) à 70°C, de sorte que les surfaces de collage sont hydrophiles. Les premier et deuxième substrats 1, 2 sont collés par collage direct à température ambiante, et à pression ambiante.

L'étape c) est exécutée en formant un revêtement fluoré sur les bords latéraux 12, 22 des premier et deuxième substrats 1, 2, de part et d'autre de l'interface de collage IC, ainsi que sur les secondes surfaces 11, 21 des premier et deuxième substrats 1, 2. Pour ce faire, l'étape c) est exécutée en faisant tourner les premier et deuxième substrats 1, 2 collés dans un bain de Novec^{™} 2702. On peut enlever le surplus de revêtement fluoré à l'aide d'un solvant (e.g. Novec^{™} 7200) et d'un rinçage avec de l'alcool isopropylique (IPA). Ce revêtement fluoré peut être retiré ultérieurement par un plasma O₂.

Afin d'obtenir une étude comparative, l'exemple de mise en œuvre n°1 a été renouvelé en l'absence d'étape c).

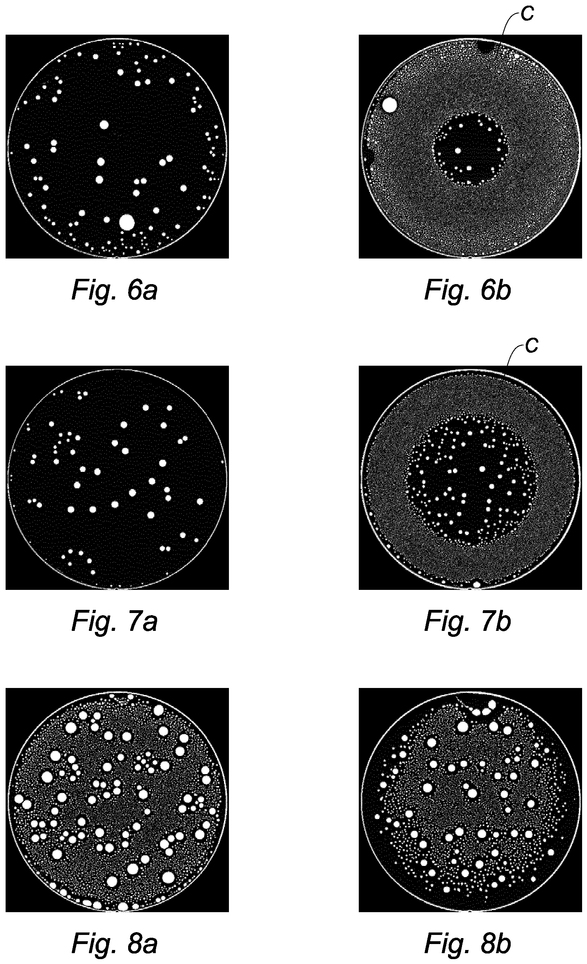

Des résultats sont illustrés aux figures 6a, 6b, après les étapes suivantes :
- un recuit thermique des substrats 1, 2 à 150°C, pendant 30 minutes ;
- immersion des substrats 1, 2 dans de l'eau liquide pendant une semaine ;
- séchage des substrats 1, 2 et recuit thermique à 300°C pendant deux heures.

On constate l'absence d'une couronne C de défauts lorsque l'étape c) est exécutée.

De la même façon, des résultats sont illustrés aux figures 7a, 7b, après les étapes suivantes :
- un recuit thermique des substrats 1, 2 à 150°C, pendant 30 minutes ;
- stockage des substrats 1, 2 dans de l'air humide (à 45% d'humidité relative) pendant une semaine ;
- séchage des substrats 1, 2 et recuit thermique à 300°C pendant deux heures.

On constate également l'absence d'une couronne C de défauts lorsque l'étape c) est exécutée.

Par ailleurs, il a été constaté que l'exécution de l'étape c) empêche également l'eau de sortir de l'interface de collage IC. Pour ce faire, l'exemple de mise en œuvre n°1 a été modifié en introduisant une étape consistant à immerger les substrats 1, 2 dans de l'eau liquide pendant 2 semaines avant l'exécution de l'étape c). En outre, comme précédemment, l'exemple de mise en œuvre n°1 modifié a été renouvelé, en l'absence d'étape c), afin d'obtenir une étude comparative.

Des résultats sont illustrés aux figures 8a, 8b, après les étapes suivantes :
- un recuit thermique des substrats 1, 2 à 150°C, pendant 30 minutes ;
- stockage des substrats 1, 2 dans une atmosphère d'azote sèche (moins de 1 ppm d'eau) pendant deux jours ;
- recuit thermique des substrats 1, 2 à 300°C pendant deux heures.

On constate la présence de la couronne C de défauts jusqu'au bord lorsque l'étape c) est exécutée, ce qui montre que l'exécution de l'étape c) empêche l'eau de sortir de l'interface de collage IC.

### Exemple de mise en œuvre n°2

Les premier et deuxième substrats 1, 2 sont deux tranches de silicium <001> de 200 mm de diamètre et de 725 µm d'épaisseur. Les premier et deuxième substrats 1, 2 sont nettoyés et hydrolysés dans des bains d'eau déionisée enrichie en ozone et dans une solution d'APM (« *Ammonia-Peroxyde Mixture* » en langue anglaise) à 70°C, de sorte que les surfaces de collage sont hydrophiles. Les premier et deuxième substrats 1, 2 sont collés par collage direct à température ambiante, et à pression ambiante.

L'étape c) est exécutée en formant un revêtement fluoré sur les bords latéraux 12, 22 des premier et deuxième substrats 1, 2, de part et d'autre de l'interface de collage IC, ainsi que sur les secondes surfaces 11, 21 des premier et deuxième substrats 1, 2. Pour ce faire, l'étape c) est exécutée en faisant tourner les premier et deuxième substrats 1, 2 collés dans un bain de Novec^{™} 1700. On peut enlever le surplus de revêtement fluoré à l'aide d'un solvant (e.g. Novec^{™} 7200 ou 7100) et d'un rinçage avec de l'alcool isopropylique (IPA). Ce revêtement fluoré peut être retiré ultérieurement par un plasma O₂.

### Exemple de mise en œuvre n°3

Les premier et deuxième substrats 1, 2 sont deux tranches de silicium <001> de 200 mm de diamètre et de 725 µm d'épaisseur. Les premier et deuxième substrats 1, 2 sont nettoyés et hydrolysés dans des bains d'eau déionisée enrichie en ozone et dans une solution d'APM (« *Ammonia-Peroxyde Mixture* » en langue anglaise) à 70°C, de sorte que les surfaces de collage sont hydrophiles. Les premier et deuxième substrats 1, 2 sont collés par collage direct à température ambiante, et à pression ambiante.

L'étape c) est exécutée en formant de la paraffine sur les bords latéraux 12, 22 des premier et deuxième substrats 1, 2, de part et d'autre de l'interface de collage IC, ainsi que sur les secondes surfaces 11, 21 des premier et deuxième substrats 1, 2. Pour ce faire, l'étape c) est exécutée en faisant tourner les premier et deuxième substrats 1, 2 collés dans un bain de paraffine fondue. La paraffine peut être retirée ultérieurement avec un solvant tel que l'acétone.

### Exemple de mise en œuvre n°4

Les premier et deuxième substrats 1, 2 sont deux tranches de silicium <001> de 200 mm de diamètre et de 725 µm d'épaisseur. Les premier et deuxième substrats 1, 2 sont nettoyés et hydrolysés dans des bains d'eau déionisée enrichie en ozone et dans une solution d'APM (« *Ammonia-Peroxyde Mixture* » en langue anglaise) à 70°C, de sorte que les surfaces de collage sont hydrophiles. Les premier et deuxième substrats 1, 2 sont collés par collage direct à température ambiante, et à pression ambiante.

L'étape c) est exécutée par un traitement hydrophobe chimique, appliqué sur les bords latéraux 12, 22 des premier et deuxième substrats 1, 2, de part et d'autre de l'interface de collage IC, ainsi que sur les secondes surfaces 11, 21 des premier et deuxième substrats 1, 2. Pour ce faire, l'étape c) est exécutée en faisant tourner les premier et deuxième substrats 1, 2 collés dans un bain de HF dilué à 10%. Un tel traitement chimique peut être annihilé ultérieurement à l'aide d'une solution d'APM à 70°C, ou à l'aide d'un plasma O₂.

### Exemple de mise en œuvre n°5

Les premier et deuxième substrats 1, 2 sont deux tranches de silicium <001> de 200 mm de diamètre et de 725 µm d'épaisseur. Les premier et deuxième substrats 1, 2 sont nettoyés et hydrolysés dans des bains d'eau déionisée enrichie en ozone et dans une solution d'APM (« *Ammonia-Peroxyde Mixture* » en langue anglaise) à 70°C, de sorte que les surfaces de collage sont hydrophiles. Les premier et deuxième substrats 1, 2 sont collés par collage direct à température ambiante, et à pression ambiante.

L'étape c) est exécutée par un traitement hydrophobe de surface, appliqué sur les bords latéraux 12, 22 des premier et deuxième substrats 1, 2, de part et d'autre de l'interface de collage IC, ainsi que sur les secondes surfaces 11, 21 des premier et deuxième substrats 1, 2. Pour ce faire, l'étape c) est exécutée en soumettant les premier et deuxième substrats 1, 2 collés à un plasma fluoré CF₄. Un tel traitement de surface peut être annihilé ultérieurement à l'aide d'une solution d'APM à 70°C, ou à l'aide d'un plasma O₂.

## Revendications

1. Procédé de collage par adhésion directe d'un premier substrat (1) à un deuxième substrat (2), comportant les étapes successives :
a) prévoir les premier et deuxième substrats (1, 2), comprenant chacun :
- une première surface (10, 20) et une seconde surface (11, 21) opposée ;
- des bords latéraux (12, 22) reliant les première et seconde surfaces (10, 20, 11, 21) ;
b) coller le premier substrat (1) au deuxième substrat (2) par une adhésion directe avec les premières surfaces (10, 20) des premier et deuxième substrats (1, 2) de manière à former une interface de collage (IC) ; l'étape b) étant un collage hydrophile entre les premier et deuxième substrats (1, 2) ; par collage hydrophile on entend que les premières surfaces (10,20) des premier et deuxième substrats (1,2) sont **caractérisées par** un angle de contact avec une goutte d'eau inférieur ou égal à 40°;
c) rendre hydrophobes les bords latéraux (12, 22) des premier et deuxième substrats (1, 2), de part et d'autre de l'interface de collage (IC); par hydrophobe on entend une surface **caractérisée par** un angle de contact avec une goutte d'eau compris entre 50° et 180°.

2. Procédé selon la revendication 1, dans lequel l'étape c) est exécutée par une formation d'une couche (4) sur les bords latéraux (12, 22) des premier et deuxième substrats (1, 2), de part et d'autre de l'interface de collage (IC), ladite couche (4) étant réalisée dans un matériau hydrophobe.

3. Procédé selon la revendication 2, dans lequel le matériau hydrophobe est sélectionné parmi la paraffine ou un revêtement fluoré.

4. Procédé selon la revendication 1, dans lequel l'étape c) est exécutée par un traitement hydrophobe des bords latéraux (12, 22) des premier et deuxième substrats (1, 2), de part et d'autre de l'interface de collage (IC).

5. Procédé selon la revendication 4, dans lequel le traitement hydrophobe est un traitement chimique, de préférence appliqué avec une solution acide ou avec des vapeurs acides.

6. Procédé selon la revendication 4, dans lequel le traitement hydrophobe est un traitement de surface, de préférence appliqué avec un plasma, plus préférentiellement un plasma fluoré.

7. Procédé selon l'une des revendications 1 à 6, dans lequel l'étape b) est suivie d'une étape consistant à appliquer un traitement thermique aux premier et deuxième substrats (1, 2) collés, le traitement thermique étant exécuté à une température comprise entre 100°C et 300°C.

8. Procédé selon l'une des revendications 1 à 7, dans lequel l'étape b) est exécutée à une température comprise entre 20°C et 30°C.

9. Procédé selon l'une des revendications 1 à 8, dans lequel l'étape c) est exécutée à l'issue de l'étape b), après une durée d'attente inférieure à 6 heures, de préférence inférieure à 1 heure, plus préférentiellement inférieure à 15 minutes.

10. Procédé selon l'une des revendications 1 à 9, dans lequel les bords latéraux (12, 22) des premier et deuxième substrats (1, 2) prévus lors de l'étape a) sont réalisés dans un matériau sélectionné parmi Si, Ge, un oxyde de silicium, SiC, un matériau III-V, un matériau II-VI.

## Patentansprüche

1. Verfahren zum Kleben, indem ein erstes Substrat (1) unmittelbar auf einem zweiten Substrat (2) zum Haften gebracht wird, wobei es nacheinander die folgenden Schritte aufweist:
a) Bereitstellen des ersten und des zweiten Substrats (1, 2), wobei jedes davon Folgendes umfasst:
- eine erste Fläche (10, 20) und eine gegenüberliegende zweite Fläche (11, 21);
- seitliche Ränder (12, 22), welche die ersten und die zweiten Flächen (10, 20, 11, 21) verbinden;
b) Kleben des ersten Substrats (1) auf das zweite Substrat (2), indem eine unmittelbare Haftverbindung mit den ersten Flächen (10, 20) des ersten und des zweiten Substrats (1, 2) derart hergestellt wird, dass sich eine Klebegrenzfläche (IC) bildet; wobei es sich bei dem Schritt b) um einen hydrophilen Klebevorgang zwischen dem ersten und dem zweiten Substrat (1, 2) handelt; wobei unter einem hydrophilen Klebevorgang zu verstehen ist, dass die ersten Flächen (10, 20) des ersten und des zweiten Substrats (1, 2) durch einen Kontaktwinkel von höchstens 40° mit einem Wassertropfen gekennzeichnet sind;
c) Hydrophobieren der seitlichen Ränder (12, 22) des ersten und des zweiten Substrats (1, 2), beiderseits der Klebegrenzfläche (IC); wobei als hydrophob eine Fläche bezeichnet wird, die durch einen Kontaktwinkel mit einem Wassertropfen gekennzeichnet ist, der im Bereich von 50° bis 180° liegt.

2. Verfahren nach Anspruch 1, wobei der Schritt c) durchgeführt wird, indem auf den seitlichen Rändern (12, 22) des ersten und des zweiten Substrats (1, 2) eine Schicht (4) gebildet wird, beiderseits der Klebegrenzfläche (IC), wobei die Schicht (4) aus einem hydrophoben Material hergestellt ist.

3. Verfahren nach Anspruch 2, wobei das hydrophobe Material aus Paraffin oder einem fluorhaltigen Überzug ausgewählt ist.

4. Verfahren nach Anspruch 1, wobei der Schritt c) durchgeführt wird, indem die seitlichen Ränder (12, 22) des ersten und des zweiten Substrats (1, 2) eine hydrophobe Behandlung erfahren, beiderseits der Klebegrenzfläche (IC).

5. Verfahren nach Anspruch 4, wobei es sich bei der hydrophoben Behandlung um eine chemische Behandlung handelt, welche vorzugsweise mit einer sauren Lösung oder mit sauren Dämpfen aufgebracht wird.

6. Verfahren nach Anspruch 4, wobei es sich bei der hydrophoben Behandlung um eine Oberflächenbehandlung handelt, welche vorzugsweise mit einem Plasma, stärker bevorzugt mit einem fluorhaltigen Plasma aufgebracht wird.

7. Verfahren nach einem der Ansprüche 1 bis 6, wobei auf den Schritt b) ein Schritt folgt, der darin besteht, das erste und das zweite Substrat (1, 2) in zusammengeklebtem Zustand einer Wärmebehandlung zu unterziehen, wobei die Wärmebehandlung bei einer Temperatur im Bereich von 100 °C bis 300 °C durchgeführt wird.

8. Verfahren nach einem der Ansprüche 1 bis 7, wobei der Schritt b) bei einer Temperatur im Bereich von 20 °C bis 30 °C durchgeführt wird.

9. Verfahren nach einem der Ansprüche 1 bis 8, wobei der Schritt c) nach Abschluss des Schrittes b) durchgeführt wird, nach einer Wartezeit von weniger als 6 Stunden, vorzugsweise von weniger als 1 Stunde, stärker bevorzugt von weniger als 15 Minuten.

10. Verfahren nach einem der Ansprüche 1 bis 9, wobei die seitlichen Ränder (12, 22) des ersten und des zweiten Substrats (1, 2), welche im Schritt a) bereitgestellt werden, aus einem Material hergestellt sind, das aus Si, Ge, einem Siliciumoxid, SiC, einem Material III-V, einem Material II-VI ausgewählt ist.

## Claims

1. Process for attaching a first substrate (1) to a second substrate (2) by direct bonding including the successive steps of:
a) providing the first and second substrates (1, 2), each comprising;
- a first surface (10, 20) and an opposite, second surface (11, 21);
- lateral edges (12, 22) connecting the first and second surfaces (10, 20, 11, 21);
b) bonding the first substrate (1) to the second substrate (2) by direct bonding with the first surfaces (10, 20) of the first and second substrates (1, 2) so as to form a bonding interface (IC); step b) being an operation of hydrophobic bonding between the first and second substrates (1, 2); what is meant by hydrophobic bonding is that the first surfaces (10, 20) of the first and second substrates (1, 2) are **characterized by** a contact angle with a drop of water that is smaller than or equal to 40°;
c) making the lateral edges (12, 22) of the first and second substrates (1, 2) hydrophobic on either side of the bonding interface (IC); what is meant by hydrophobic is a surface **characterized by** a contact angle with a drop of water of between 50° and 180°.

2. Process according to Claim 1, wherein step c) is carried out by forming a layer (4) on the lateral edges (12, 22) of the first and second substrates (1, 2) on either side of the bonding interface (IC), said layer (4) being produced in a hydrophobic material.

3. Process according to Claim 2, wherein the hydrophobic material is selected from paraffin wax or a fluorinated coating.

4. Process according to Claim 1, wherein step c) is carried out by applying a hydrophobic treatment to the lateral edges (12, 22) of the first and second substrates (1, 2) on either side of the bonding interface (IC).

5. Process according to Claim 4, wherein the hydrophobic treatment is a chemical treatment, preferably applied by means of an acid solution or by means of acid vapour.

6. Process according to Claim 4, wherein the hydrophobic treatment is a surface treatment, preferably applied by means of a plasma, more preferably a fluorine-based plasma.

7. Process according to one of Claims 1 to 6, wherein step b) is followed by a step consisting in applying a heat treatment to the bonded first and second substrates (1, 2), the heat treatment being carried out at a temperature of between 100°C and 300°C.

8. Process according to one of Claims 1 to 7, wherein step b) is carried out at a temperature of between 20°C and 30°C.

9. Process according to one of Claims 1 to 8, wherein step c) is carried out subsequent to step b), after a waiting time of less than six hours, preferably less than one hour, more preferably less than 15 minutes.

10. Process according to one of Claims 1 to 9, wherein the lateral edges (12, 22) of the first and second substrates (1, 2) provided in step a) are produced in a material selected from Si, Ge, a silicon oxide, SiC, a III-V material, a II-VI material.
